# EUROPEAN PATENT APPLICATION

(11) **EP 4 727 268 A1**
(43) Date of publication of application: **15.04.2026**
(21) Application number: 25205279.0
(22) Date of filing: 29.09.2025
(51) Int. Cl.: H05K 1/11, H05K 3/3452

(54) **CIRCUIT BOARD WITH SEMI-SOLDER MASK DEFINED PAD AND METHOD OF MANUFACTURING SAME**

(30) Priority: 11.10.2024 US 202418913152
(71) Applicant: STMicroelectronics International N.V., 1228 Plan-les-Ouates, Geneva (CH)
(72) Inventor: HALLIDAY, William, Edinburgh, EH12 8EX (GB)
(74) Representative: Casalonga

(57) **Abstract**

In accordance with various embodiments of the present disclosure, a circuit board is provided that comprises a substrate (202), a metal layer (204) covering a portion of the substrate and forming at least one metal pad, and a solder mask (206) at least partly covering the metal layer and defining at least one opening. The at least one opening corresponds to the at least one metal pad such that opposing first and second edges of the metal pad are exposed within the at least one opening and opposing third and fourth edges of the metal pad are covered by the solder mask.

## Description

### FIELD OF THE INVENTION

Example embodiments of the present disclosure relate generally to circuit boards pads and, in particular, to semi-solder mask defined circuit board pads.

### BACKGROUND

A pad is an exposed region of metal (typically copper) on a printed circuit board (PCB) to which a component lead is soldered. There are basically three different kinds of pads, as determined by how the pads are formed: solder mask defined (SMD) pads, non-solder mask defined (NSMD) pads, and semi-solder mask defined (SSMD) pads.

SMD pads are defined by apertures in the solder mask. In such an SMD pad, the aperture in the solder mask is smaller than the underlying copper pad applied over a copper layer. In NSMD pads, there is a gap between the edge of the copper pad and the solder mask. That is, the solder mask does not overlap the copper pad.

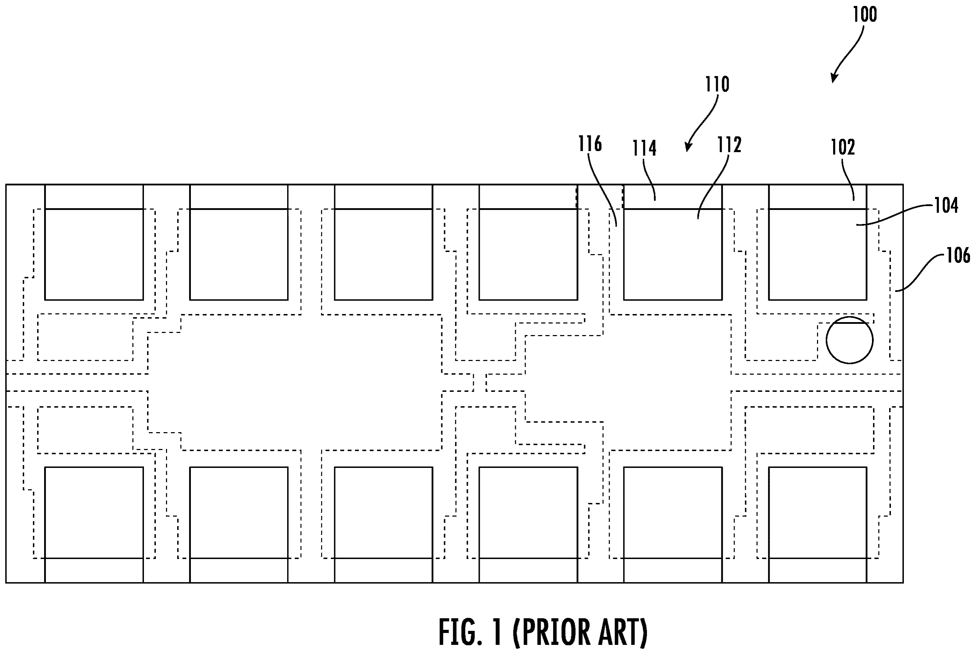

In semi-solder mask defined (SSMD) pads, at least one edge is defined by the solder mask and the remainder are defined by the copper pad. Figure 1 illustrates a PCB 100 comprising a substrate 102 with one or more conductive layers 104 (typically comprising copper) in which traces have been etched to form electrical connections, and a solder mask 106 on top of the copper layer 104. Openings in the solder mask are located to expose parts of the copper layer to enable components, wire leads, etc., to be soldered to the PCB. Such exposed areas of the copper layer are termed pads.

The PCB 100 of FIG. 1 has twelve SSMD pads 110 (six along the top edge and six along the bottom edge). As seen in FIG. 1, all of the SSMD pads 110 have three SMD sides and one NSMD side (for each of the six pads along the top, the top edge is NSMD; for each of the six pads along the bottom, the bottom edge is NSMD). Each SSMD pad 110 has a copper pad 112, and a corresponding opening in the solder mask 106 such that there is an exposed portion of substrate 114 on one side of the copper pad 112 and three sides 116 of the copper pad is covered by the solder mask 106. Because the solder mask is typically semitransparent, the underlying edges of the copper pads are somewhat visible on each of the SMD sides (this is indicated in FIG. 1 by the dashed lines).

Having the top and bottom edges be NSMD edges (as in FIG. 1) enables "edge on" inspection of the solder joints (i.e., visual inspection from the top and bottom edges of the PCB) which is desirable in many cases.

When the solder mask is applied to the PCB, there may be a registration error in which the solder mask is not placed precisely where intended. Such registration errors of up to 30 microns are typically allowable and planned for in PCB design. Such registration errors typically do not cause any issues with SMD or NSMD pads, as enough overlap is built into the design to accommodate a registration error within specified tolerances. However, such a registration error in an SSMD pad may cause inconsistent pad sizes which can, in turn, cause other problems with the construction of the PCB (especially in very small PCBs)

Consider the example PCB 100 in FIG. 1. If the solder mask is shifted left or right (within a specified tolerance), the pad sizes remain consistent because the amount of copper pad uncovered on one side due to the shift is equal to the amount of copper pad covered on the other side due to the shift. However, if the solder mask is shifted up or down, some pads will become larger and some pads will become smaller. For example, if the solder mask is shifted up, the top row of pads will become smaller (because more of the bottom edge of those pads is now covered by the solder mask) and the bottom row of pads will become larger (because less of the top edge of those pads is now covered by the solder mask). Conversely, if the solder mask is shifted down, the top row of pads will become larger (because less of the top edge of those pads is now covered by the solder mask) and the bottom row of pads will become smaller (because more of the bottom edge of those pads is now covered by the solder mask).

Because a predetermined amount of solder is applied to each pad, there will be too much solder if the pad becomes smaller due to a registration error and too little solder if the pad becomes larger due to a registration error. Typically components with two pads, or more complicated components with dual in-line pad layouts, which have pads of this nature can be adversely affected by this registration error. If those two pads (or two lines of pads) are not the correct size because of a solder mask registration error, many different problems can result. For example, the component may not sit level on the PCB and a dry solder joint may result. Such effects are exacerbated on small reflowable packages.

Applicant has identified many technical challenges and difficulties associated with SSMD pads in PCBs. Through applied effort, ingenuity, and innovation, Applicant has solved problems related SSMD pads in PCBs by developing solutions embodied in the present disclosure, which are described in detail below.

### BRIEF SUMMARY

Various embodiments described herein related to circuit boards with one or more SSMD pads, and methods for manufacturing circuit boards with one or more SSMD pads.

In accordance with various embodiments of the present disclosure, a circuit board is provided that comprises a substrate, a metal layer covering a portion of the substrate and forming at least one metal pad, and a solder mask at least partly covering the metal layer and defining at least one opening. The at least one opening corresponds to the at least one metal pad such that opposing first and second edges of the metal pad are exposed within the at least one opening and opposing third and fourth edges of the metal pad are covered by the solder mask.

In some embodiments, the at least one metal pad has a first dimension and a second dimension substantially perpendicular to the first dimension of the at least one metal pad, the at least one opening has a first dimension and a second dimension substantially perpendicular to the first dimension of the at least one opening, the first dimension of the at least one metal pad is substantially parallel to the first dimension of the at least one opening, the second dimension of the at least one metal pad is substantially parallel to the second dimension of the at least one opening, the first dimension of the at least one opening is greater than or equal to the first dimension of the at least one metal pad plus two times a predefined mask registration error tolerance, and the second dimension of the at least one metal pad is greater than or equal to the second dimension of the at least one opening plus two times the predefined mask registration error tolerance.

In some embodiments, the at least one metal pad is substantially rectangular and the at least one opening is substantially rectangular.

In some embodiments, an edge of the at least one opening abuts an edge of the substrate.

In some embodiments, the substrate comprises an organic substrate.

In some embodiments, the metal layer comprises copper.

In some embodiments, the circuit board comprises a land grid array.

In accordance with various embodiments of the present disclosure, a method of manufacturing a circuit board is provided that comprises forming at least one metal pad from a metal layer covering a portion of a substrate; and applying a solder mask at least partly covering the metal layer and defining at least one opening. The at least one opening corresponds to the at least one metal pad such that opposing first and second edges of the metal pad are exposed within the at least one opening and opposing third and fourth edges of the metal pad are covered by the solder mask.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a top view of a circuit board with conventional SSMD pads;
FIG. 2A is a top view of an example circuit board with example SSMD pads, in accordance with some embodiments of the present disclosure;
FIG. 2B is a close-up view of an example SSMD pad of the example circuit board of FIG. 2A; and
FIG. 3 is a top view of the example circuit board of FIG. 2A with a solder mask registration error, in accordance with some embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Various embodiments of the present disclosure overcome the above technical challenges and difficulties and provide various technical improvements and advantages based on, for example, but not limited to, providing PCBs and method of manufacturing PCBs which comprise one or more SSMD pads in which two opposing edges are defined by the solder mask (i.e., SMD) and the other two opposing edges are defined by the copper pad (i.e., NSMD).

In various embodiments, the copper pad is wider (in one direction, e.g., horizontal) than the solder mask opening by a value greater than twice the allowable solder mask registration error, and the copper pad is narrower than the solder mask opening by a value greater than twice the allowable solder mask registration error in the perpendicular (e.g., vertical) direction.

In various embodiments, the layout of the solder mask is designed such that a precise placement of the solder mask would result in an exposed portion of substrate on each of two opposing sides of the pad that is at least as large as the allowable solder mask registration error and would result in a covered portion of the copper pad on each of the other two opposing sides of the pad that is at least as large as the allowable solder mask registration error. As a result and as described further below, the SSMD pads of various embodiments allow a vertical (up or down) and/or horizontal (left or right) solder mask registration error within the predefined tolerance to occur without changing the size of the exposed copper portion of the pad.

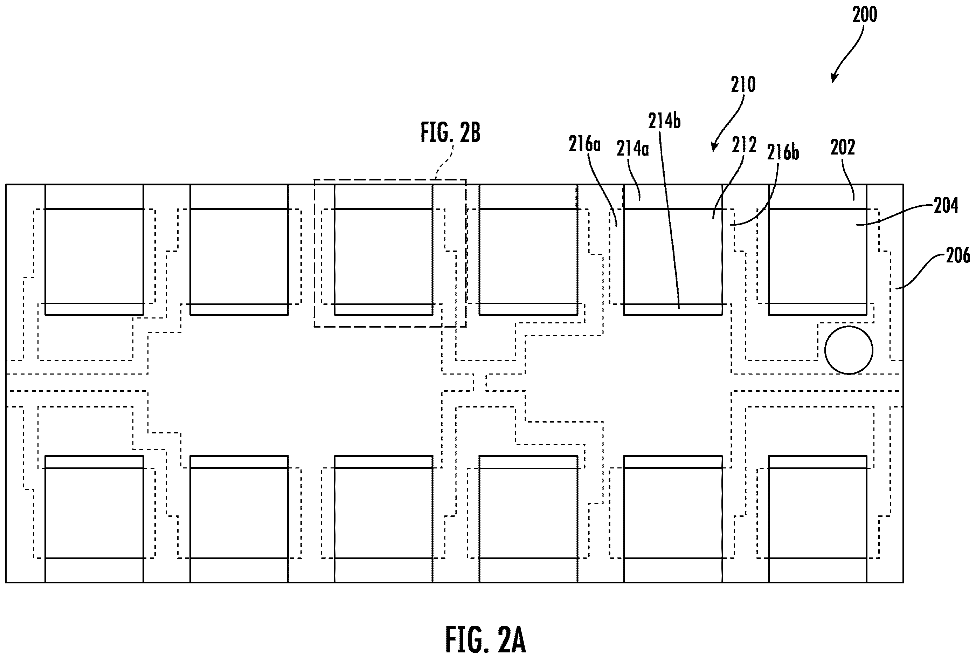

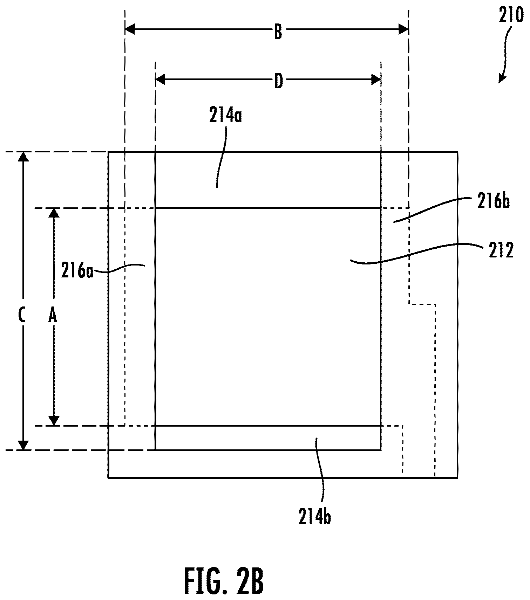

FIG. 2A illustrates an example circuit board with a plurality of example SSMD pads, in accordance with some embodiments of the present disclosure. FIG. 2B is a close-up view of an example SSMD pad of the example circuit board of FIG. 2A. As seen in FIG. 2A, an example PCB 200 comprises a substrate 202 with one or more conductive layers 204 (typically comprising copper) in which traces have been etched to form electrical connections, and a solder mask 206 on top of the copper layer 204. Because the solder mask is typically semitransparent, the underlying edges of the copper pads are somewhat visible on each of the SMD sides (this is indicated in FIGS. 2A and 2B by the dashed lines). In various embodiments, the circuit board 200 may be a land grid array. In various embodiments, the substrate may comprise an organic substrate, however any suitable type of substrate may be used.

The PCB 200 of FIG. 2A has twelve SSMD pads 210 (six along the top edge and six along the bottom edge). As seen in FIGS. 2A and 2B, each of the SSMD pads 210 have a copper pad 212 and a corresponding opening 218 in the solder mask 206 such that there is an exposed portion of substrate 114a, 114b on opposing sides of the copper pad 112 and the other two opposing sides 116a, 116b of the copper pad are covered by the solder mask 206. That is, the copper pad 212 of FIGS. 2A and 2B has two opposing SMD sides (left and right in FIGS. 2A and 2B) in which the edges of the copper 216a, 216b are covered by the solder mask and two opposing NSMD sides (top and bottom in FIGS. 2A and 2B) in which the edges of the copper and adjacent portions of the substrate 214a, 214b are exposed. In various embodiments, the exposed metal portions of the SSMD pads are rectangular. In various embodiments, because each SSMD pad has exposed substrate adjacent to an outer edge of the PCB, "edge on" inspection of the solder joints (i.e., visual inspection from the top and bottom edges of the PCB) is enabled.

As seen in FIG. 2B, the copper pad 212 has a first dimension A and a second dimension B that is substantially perpendicular to the first dimension A, and the opening 218 defined by the solder mask has a first dimension C and a second dimension D that is substantially perpendicular to the first dimension C. The first dimension A of the copper pad 212 is substantially parallel to the first dimension C of the solder mask opening 218, and the second dimension B of the copper pad 212 is substantially parallel to the second dimension D of the solder mask opening 218. In the arrangement of FIG. 2B, dimension A and dimension C may be considered heights, while dimension B and dimension D may be considered widths.

In various embodiments, the first dimension C of the solder mask opening 218 is greater than or equal to the first dimension A of the copper pad 212 plus two times the predefined mask registration error tolerance, and the second dimension B of the copper pad 212 is greater than or equal to the second dimension D of the solder mask opening 218 plus two times a predefined mask registration error tolerance.

In one example embodiment, first dimension A of the copper pad 212 is 0.400 millimeters (mm), the second dimension B of the copper pad 212 is 0.525 mm, the first dimension C of the solder mask opening 218 is 0.550 mm, and the second dimension D of the solder mask opening 218 is 0.425 mm. In such an example embodiment, the exposed portion of the copper pad is 0.400 mm by 0.425 mm. In such an example embodiment, the predefined mask registration error tolerance is 0.030 mm.

In various embodiments, having an SSMD pad in which two opposing edges are SMD and the other two opposing edges are NSMD accommodates a solder mask registration error (up to the allowable amount) in any direction without changing the size of the pad. In various embodiments, if the solder mask is shifted left or right (within the specified tolerance), the pad sizes remain consistent (as in the prior art) because the amount of copper pad uncovered on one side due to the shift is equal to the amount of copper pad covered on the other side due to the shift. Similarly, if the solder mask is shifted up or down, the pad sizes remain consistent. Because the gap between the copper pad and the solder mask is greater than the allowable registration error, an upward shift of the solder mask will not cause the solder mask to cover any of the bottom edges of the top row of pads and a downward shift of the solder mask will not cause the solder mask to cover any of the top edges of the bottom row of pads.

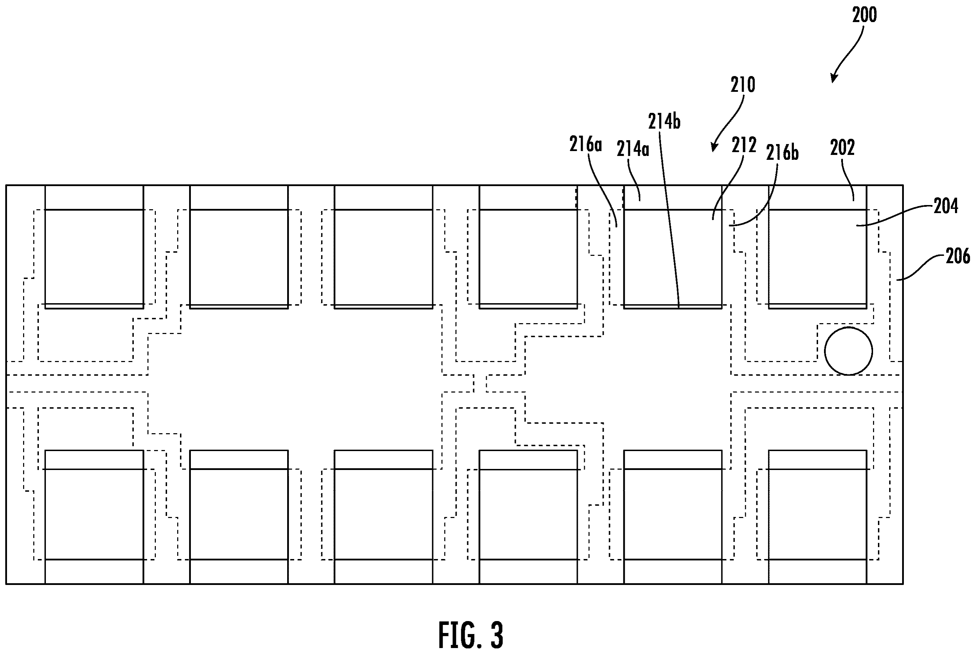

This is illustrated in FIG. 3 in which the solder mask 206 has been shifted upward by less the predefined mask registration error tolerance. As seen in FIG. 3, in the top row of SSMD pads, the exposed substrate 214b at the bottom of each SSMD pad has gotten smaller but no additional amount of the exposed portion in the top row of SSMD pads has been covered by the solder mask and therefore the size of the exposed portion of the copper pad has not changed despite the upward shift of the solder mask. Similarly, in the bottom row of SSMD pads, the upward shift of the solder mask 206 has caused more of the substrate adjacent the top edge of each copper pad to be exposed but has not changed the size of the exposed portion of the copper pads.

Although not illustrated, if the solder mask 206 had been shifted downward by less the predefined mask registration error tolerance, in the bottom row of SSMD pads the exposed substrate at the top of each SSMD pad would have gotten smaller but no additional amount of the exposed portion would have been covered by the solder mask. Similarly, in the top row of SSMD pads, the exposed substrate at the bottom of each SSMD pad would have gotten larger but the size of the exposed portion of the copper pads would not change. Although not illustrated, if the solder mask 206 had been shifted leftward or rightward, the additional amount of the copper pad now covered on one side would be equal to the additional amount of the copper pad now uncovered on the other side.

Because the exposed metal portion of the SSMD of various embodiments remains consistent in spite of such solder mask shift, the amount of solder deposited will be consistent and equal.

Various embodiments of the disclosure provide one or more of the following benefits: better package placement with reduced tilt, tighter assembly tolerances, smaller solder volumes while maintaining joint reliability as tilt will not contribute to dry joint issues, post-assembly visual inspection of joints is retained, and solder-mask separation of adjacent joints is retained.

While tilt and placement tolerances are vital for optical packages, embodiments of the present disclosure are applicable at least to all small-sized land grid array (LGA) packages based on an organic substrate with a solder mask to improve mechanical assembly tolerances, solder joint uniformity, and reliability. In various embodiments on products with square arrangements of pads, placement tolerances can be improved in both X and Y directions. In various embodiments during testing, because the solder-mask opening is elongated, there is more clearance area for the test pogo-pin to contact the pad without clipping the edge of the solder mask which can cause poor electrical contact and socket contamination risk.

### Conclusion

Many modifications and other embodiments of the disclosures set forth herein will come to mind to one skilled in the art to which these disclosures pertain having the benefit of teachings presented in the foregoing descriptions and the associated drawings. Although the figures only show certain components of the apparatus and systems described herein, it is understood that various other components may be used in conjunction with the system. Therefore, it is to be understood that the disclosures are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above.

Additionally, the section headings used herein are provided for consistency with the suggestions under 37 C.F.R. 1.77 or to otherwise provide organizational cues. These headings shall not limit or characterize the disclosure(s) set out in any claims that may issue from this disclosure.

While this detailed description has set forth some embodiments of the present disclosure, the appended claims cover other embodiments of the present disclosure which differ from the described embodiments according to various modifications and improvements. For example, the appended claims can cover any form of circuit board having SSMD pads, such as land grid arrays. As another example, the appended claims can cover Wafer-Level Chip-Scale Packaging, where the RDL layer is formed on the wafer back-side, typically comprising of a polyimide layer, then a copper routing layer, finished with solder-resist layer to form pads.

Within the appended claims, unless the specific term "means for" or "step for" is used within a given claim, it is not intended that the claim be interpreted under 35 U.S.C. 112, paragraph 6.

## Claims

1. A circuit board comprising:
a substrate (202);
a metal layer (204) covering a portion of the substrate and forming at least one metal pad; and
a solder mask (206) at least partly covering the metal layer and defining at least one opening, the at least one opening corresponding to the at least one metal pad such that opposing first and second edges of the metal pad are exposed within the at least one opening and opposing third and fourth edges of the metal pad are covered by the solder mask.

2. The circuit board of claim 1, wherein
the at least one metal pad has a first dimension and a second dimension substantially perpendicular to the first dimension of the at least one metal pad;
the at least one opening has a first dimension and a second dimension substantially perpendicular to the first dimension of the at least one opening;
the first dimension of the at least one metal pad is substantially parallel to the first dimension of the at least one opening;
the second dimension of the at least one metal pad is substantially parallel to the second dimension of the at least one opening;
the first dimension of the at least one opening is greater than or equal to the first dimension of the at least one metal pad plus two times a predefined mask registration error tolerance; and
the second dimension of the at least one metal pad is greater than or equal to the second dimension of the at least one opening plus two times the predefined mask registration error tolerance.

3. The circuit board of claim 1 or claim 2, wherein the at least one metal pad is substantially rectangular and wherein the at least one opening is substantially rectangular.

4. The circuit board of any one of claims 1 to 3, wherein an edge of the at least one opening abuts an edge of the substrate.

5. The circuit board of any one of claims 1 to 4, wherein the substrate comprises an organic substrate.

6. The circuit board of any one of claims 1 to 5, wherein the metal layer comprises copper.

7. The circuit board of any one of claims 1 to 6, wherein the circuit board comprises a land grid array.

8. A method of manufacturing a circuit board, the method comprising:
forming at least one metal pad from a metal layer (204) covering a portion of a substrate (202); and
applying a solder mask (206) at least partly covering the metal layer and defining at least one opening, the at least one opening corresponding to the at least one metal pad such that opposing first and second edges of the metal pad are exposed within the at least one opening and opposing third and fourth edges of the metal pad are covered by the solder mask.

9. The method of claim 8, wherein
the at least one metal pad has a first dimension and a second dimension substantially perpendicular to the first dimension of the at least one metal pad;
the at least one opening has a first dimension and a second dimension substantially perpendicular to the first dimension of the at least one opening;
the first dimension of the at least one metal pad is substantially parallel to the first dimension of the at least one opening;
the second dimension of the at least one metal pad is substantially parallel to the second dimension of the at least one opening;
the first dimension of the at least one opening is greater than or equal to the first dimension of the at least one metal pad plus two times a predefined mask registration error tolerance; and
the second dimension of the at least one metal pad is greater than or equal to the second dimension of the at least one opening plus two times the predefined mask registration error tolerance.

10. The method of claim 8 or claim 9, wherein the at least one metal pad is substantially rectangular and wherein the at least one opening is substantially rectangular.

11. The method of any one of claims 8 to 10, wherein an edge of the at least one opening abuts an edge of the substrate.

12. The method of any one of claims 8 to 11, wherein the substrate comprises an organic substrate.

13. The method of any one of claims 8 to 12, wherein the metal layer comprises copper.

14. The method of any one of claims 1 to 13, wherein the circuit board comprises a land grid array.
